Europäisches Patentamt

European Patent Office

Office européen des brevets

(19)

(11) **EP 1 070 966 A1**

(12) **EUROPEAN PATENT APPLICATION**

(43) Date of publication:
24.01.2001 Bulletin 2001/04

(51) Int Cl.⁷: **G01R 31/08**, G01R 31/28, G01R 31/00

(21) Application number: 99114388.4

(22) Date of filing: 22.07.1999

(84) Designated Contracting States:
**AT BE CH CY DE DK ES FI FR GB GR IE IT LI LU MC NL PT SE**
Designated Extension States:
**AL LT LV MK RO SI**

(71) Applicant: **SIEMENS AKTIENGESELLSCHAFT**
**80333 München (DE)**

(72) Inventors:
• **Ruoss, Hans-Oliver**
**70569 Stuttgart (DE)**
• **Faessler, Georg**
**9440 Aabybro (DK)**
• **Klar, Michael**
**72116 Mössingen (DE)**
• **Spreitzer, Wolfgang**
**78564 Weihingen (DE)**

(54) **A method and device for determining the electrical field strength acting on an anatomical model**

(57) The present invention provides a device for determining the electrical field strength acting on an anatomical model (10) made of a solid material and having a predetermined material distribution comprising a probe matrix arranged on the surface of said anatomical model (10), said probe matrix comprising a plurality of individual probes (100-111) for measuring a parameter reflecting the electrical field strength at the probe location; and a controller (50) for controlling the measurement of the individual probes (100-111) and for performing a numerical transformation on the measured field strength values in order to obtain field strength values at locations within the interior of said anatomical model (10). The invention also provides a corresponding method.

FIG 1A

EP 1 070 966 A1

FIG 1B

5

109

111

A

50

A'

110

EW

10

**Description**

BACKGROUND OF THE INVENTION

The present invention relates to a method and device for determining the electrical field strength acting on an anatomical model.

Although applicable to any electrical field strength acting on an anatomical model, the present invention and its underlying problems will be discussed with particular reference to the electric field strength generated by a mobile phone system acting on an anatomical model or phantom, because there is an ongoing discussion as to whether mobile phone systems are dangerous to human health or not, and therefrom the topic is generally known.

In general, electric and electronic devices generate electromagnetic fields in their surroundings which - for reasons of personal safety and influences on other devices - are not allowed to exceed certain limits. These limits have to be maintained in the total area, in defined distances and within the human body or within regions thereof.

In order to have a quantitative measure of the influence of an electromagnetic field, usually the specific absorption rate (SAR) is determined. For this parameter SAR there are certain regulated limit values. As a function of the location, the parameter SAR is a measure of the power distribution related to the mass of the tissue. It may be obtained from the following relation:

$$SAR = \frac{\partial}{\partial t}\left[\frac{\Delta W}{\Delta m}\right] = \frac{1}{\rho}\cdot\frac{\partial}{\partial t}\left[\frac{\Delta W}{\Delta V}\right] \qquad (1)$$

Wherein $\partial/\partial t$ is the partial time derivative, $\Delta W$ is the energy which is absorbed from a mass $\Delta m$. This mass is presumably contained in a volume element $\Delta V$ having constant material density $\rho$.

The determination of the SAR distribution may be performed indirectly by measuring the temperature increase of the tissue or by the sensorical or numerical direct determination of the electric field strength in the interior of the body.

In the latter case, the parameter SAR is given by

$$SAR(\vec{r}) = \frac{1}{2}\frac{\sigma}{\rho}\cdot\left|\vec{E}(\vec{r})\right|^2 \qquad (2)$$

wherein E is the amplitude of the electrical field strength in a tissue having the conductivity $\sigma$ and the material density $\rho$.

In order to determine the parameter SAR according to equation (2), i.e. in a non-thermal way, it is necessary to know the local distribution of the electric field strength in the interior of the human body or a suitable anatomical model, also called phantom.

Usual methods and devices for determining the electrical field strength acting on an anatomical model are limited to the determination of the electric field strength directly in the interior of the model or phantom. The following publications deal with these usual methods and devices:

N. Kuster: Energy Absorption Mechanism by Biological Bodies in the Near Field of Dipole Antennas above 300 MHz. IEEE Transactions on Vehicular Technology, vol. 41, no 1, pp. 17-23, Feb. 1992;

K. Meier, O. Egger, T. Schmid and N. Kuster: Dosimetric laboratory for mobile communications. Proceedings of the 11th International Zurich Symposium on Electromagnetic Compatibility, pp. 297-300 (5518), March 1995;

N. Kuster: Automated E-Field Scanning System for Dosimetric Assessments. IEEE Transactions on Microwave Theory and Techniques, vol. 44, no. 1, pp. 105-113, Jan. 1996;

T. Schmid, O. Egger and N. Kuster: Automated E-field scanning system for dosimetric assessments. IEEE Transactions on Vehicular Technology, vol. 44, no. 1, pp. 105-113, Jan. 1996; and

K. Meier, M. Burkhardt, T. Schmid and N. Kuster: Broadband calibration of E-field probes in lossy media. IEEE Transactions on Microwave Theory and Techniques, vol. 44, no. 10, pp. 1954-1962, Oct. 1996.

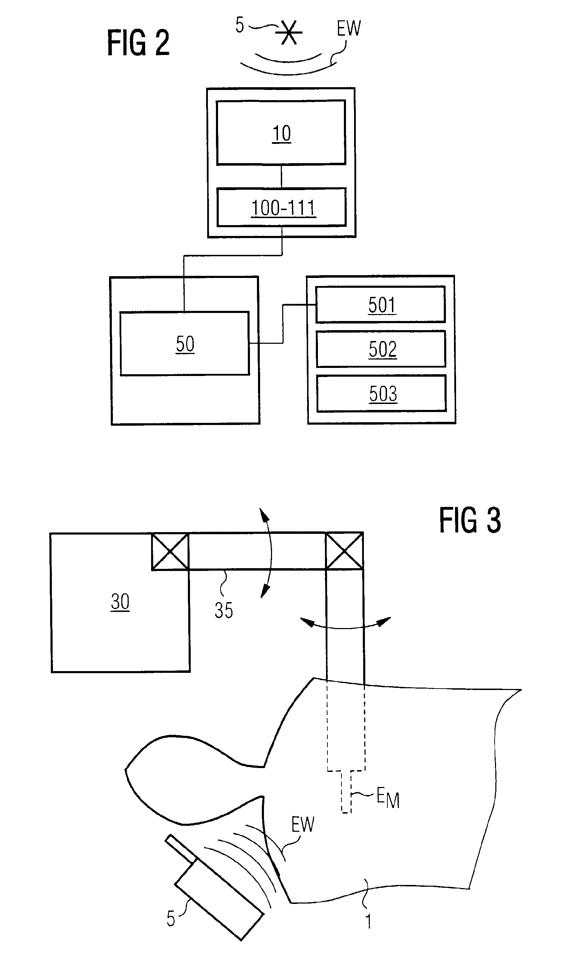

Fig. 3 depicts an illustration of a usual device for determining the electrical field strength acting on an anatomical model.

In figure 3 reference sign 1 denotes an anatomical model in form of a phantom representing the human body, 5 a mobile phone sending an electromagnetic wave EW, 30 a robot having a robot arm 35 which is movable and which has an electric field probe attached to the tip of said robot arm 35 for measuring the electric field strength $E_M$ at the probe location.

In this known device, the phantom 1 is filled with a liquid or a jelly and has an appropriate opening or is cut off in a certain region in order to allow the insertion of the electric field probe attached to the tip of said robot arm 35 for measuring the electric field strength $E_M$ at the probe location. The robot arm 35 automatically scans the body in order to obtain the electric field strength at desired locations, sequentially.

The essential disadvantages of the above mentioned usual methods and devices for determining the electrical field strength within a phantom are the following.

A huge number of scan points for a 3-dimensional scan and extremely long measuring times are required. The interior of the phantom has to be accessible or approachable from the exterior, and has to be filled with a fluid or a jelly simulating the tissue in order to be able to apply the probe and measure a realistic field. The properties of the liquid change with time which leads to a time-consuming refill and recalibration procedure. Moreover, a certain distance is required between the probe and the surface of the phantom due to the dimensions of the probe and the geometry of the phantom. Thus, the SAR values on the surface of the phantom have to be extrapolated.

SUMMARY OF THE INVENTION

The present invention provides a Method for Determining the Electrical Field Strength acting on an Anatomical Model according to claim 1 and a corresponding device according to claim 6.

The method and device according to the invention provide a fast and accurate way of determining the electric field or SAR distribution in an anatomical model made of a solid material by quasi-simultaneously measuring the electric field strength by means of appropriate field probes arranged on the surface of said anatomical model. The determination of the electric field within the interior of the anatomical model is then achieved by a numerical transformation of the field strength sensed by the different probes on the surface to the interior of the phantom in order to calculate the parameter SAR.

A particular advantage of the method and device according to the invention is that the measuring time is drastically reduced because of the quasi-simultaneously measuring with the probe matrix including said plurality of individual probes and the field transformation to determine the electric field strength within the interior of the anatomical model. Quantitatively, this measuring time reduction provides an improvement from the range of hours to the range of seconds. In order to obtain the SAR values at locations within the interior of said anatomical model, no extrapolation is needed any more. Since the interior of the phantom has not to be accessible any more, no fluid is needed in order to simulate the tissue.

Preferred embodiments of the present invention are listed in the dependent claims.

According to a preferred embodiment, the material of said anatomical model is chosen to be essentially homogeneous and with constant mass density. This simplifies the calculation of the field points.

According to a further preferred embodiment, a calculation of the SAR values at locations within the interior of said anatomical model from said field strength values at locations within the interior of said anatomical model is performed.

According to a further preferred embodiment, the step of performing a numerical transformation includes solving the occurring differential equations and the corresponding border value problem, preferably including a formulation with equivalent sources or a multipole evaluation.

According to a further preferred embodiment, the step of performing a numerical transformation includes using a Green Function in order to solve the occuring differential equations such that the measured field strength values at locations on the surface of said anatomical model yield sources of the field within the interior of said anatomical model in accordance with the Huygen' s principle.

BRIEF DESCRIPTION OF THE DRAWINGS

The present invention will become more fully understood by the following detailed description of preferred embodiments thereof in conjunction with the accompanying drawings, in which:

Fig. 1a,b    depict an illustration of a device for determining the electrical field strength acting on an anatomical model according to an embodiment of the invention;

Fig. 2    shows a block diagramm illustration of the components and functions of the embodiment shown in Fig.

1; and

Fig. 3       depicts an illustration of a usual device for determining the electrical field strength acting on an anatomical model.

## DESCRIPTION OF THE PREFERRED EMBODIMENTS

In the figures, the same reference signs denote the same or equivalent elements.

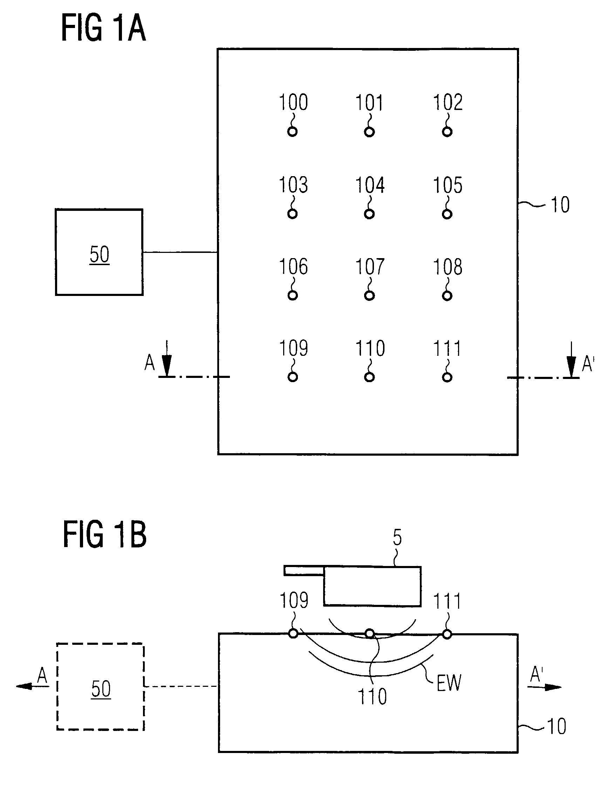

Fig. 1a,b depict an illustration of a device for determining the electrical field strength acting on an anatomical model according to an embodiment of the invention where Figure 1b shows a cross-section along the line AA' of figure 1a.

In figure 1a,b 100-111 denote a plurality of individual probes arranged in matrix form on the surface of the anatomical model 10 which in this example has the simple form of a rectangular solid. The manufacture of the phantom 10 of a solid-state material is of advantage.

A suitable material for the phantom 10 is, for example, a mixture of ceramics powder (for adjusting the relative permittivity $\varepsilon$), graphite powder (for adjusting the conductivity $\sigma$) and plastic as carrier material.

The probes 100-111 serve for measuring a parameter reflecting the electrical field strength at the probe location such as dipole antennas for measuring the phase and intensity of the electromagnetic waves EW originating from the mobile phone 5 which is arranged in a predetermined distance to the surface of said anatomical model 10. The probes 100-111 have fixed locations and need not to be moved like in usual devices. In order to guarantee a short measuring time, it is preferred to arrange the probes 100-111 in form of a particular matrix. An important point is the derivation of the signals from the probes 100-111. This derivation can be achieved by means of high resistive transmission lines having a high resistance value such that the electric field to be measured is only weakly influenced.

The output signals of the probes 100 to 111 are fed by a not-shown wiring to a controller 50.

Fig. 2 shows a block diagramm illustration of the components and functions of the embodiment shown in Fig. 1.

As shown in Fig. 2, particular functions of the controller 50 are 501 the control of the measurement, 502 performing the numerical transformation on the measured field strength values on the probe locations in order to obtain field strength values at locations within the interior of said anatomical model 10, and corresponding analysis 503. Preferably, said results are visualised on a not-shown screen connected to the controller 50.

In the following, a typical measurement is described.

In a first step, said anatomical model 10 made of a solid material and having a predetermined, preferably homogeneous, material distribution is provided.

Then, the probe matrix is fixed on the surface of said anatomical model 10, said probe matrix comprising a plurality of individual probes for measuring a parameter reflecting the electrical field strength at the probe location.

For selecting particular probes and for sensing and detecting the measuring values, the controller 50 is required. Thus, in a next step of the measuring procedure, a distribution of the local electric field strength values on the surface of the anatomical model 10 is obtained in a quasi-simulaneously way which means that no sequential procedure as with currently known devices is any longer necessary, but all probes 100-111 may give their results quasi-simultaneously.

Then, the controller 50 performs a numerical transformation on the measured field strength values in order to obtain field strength values at locations within the interior of said anatomical model 10.

The basis for determining the field strength at locations within the interior of the phantom starting from said measured field strength values on the surface is the potential theory. The accurate formulation of the solution of said problem is possible by applying different methods. See, f.e., J.A. Stratton, Electromagnetic Theory, McGraw Hill, New York 1941.

For example, a field-oriented approach for solving the occurring differential equations is the solution of a border value problem. This approach may include eqivalent sources or a multipole evaluation, for example.

An entire domain approach may lead to the use of a Green Function when solving the differential equations. This approach may be interpreted such that the measured field strength values at locations on the surface of said anatomical model 10 yield sources of the field within the interior of said anatomical model 10 in accordance with the Huygen's Principle. If equivalent or fictive surface current densities are taken, the problem may be solved by applying the method of moments. For electrically large scattering bodies, also asymptotic methods for the higher frequency range, for example the method of physical optics, may be applied.

Finally, a step of calculating the SAR values at locations within the interior of said anatomical model from said obtained field strength values at locations within the interior of said anatomical model may be performed.

Although the present invention has been described with respect to preferred embodiments thereof, it should be understood that many modifications can be performed without departing from the scope of the invention as defined by the appended claims.

Particularly, the probes for measuring the electric field strength may also be monopoles, patch antennas or electro-optical field probes.

Although in the foregoing the anatomical model has been assumed as a simple geometrical body, it is of course possible to use more complicated shapes. Moreover, the probes may be distributed anywhere on the surface of the anatomical model.

Furthermore, it is possible to use a robot in order to vary the location of the source 5 of the electromagnetic radiation. Finally, the probes may either measure the electric field strength directly or a parameter reflecting the electric field strength.

Also, any possible numerical transformation for obtaining the internal electric field strength values may be applied.

**Claims**

1. A method for determining the electrical field strength acting on an anatomical model comprising the steps of:

    providing said anatomical model made of a solid material and having a predetermined material distribution;

    arranging a probe matrix on the surface of said anatomical model, said probe matrix comprising a plurality of individual probes for measuring a parameter reflecting the electrical field strength at the probe location;

    quasi-simultaneously measuring the electrical field strength at the probe locations on the surface of said anatomical model; and

    performing a numerical transformation on the measured field strength values in order to obtain field strength values at locations within the interior of said anatomical model.

2. The method according to claim 1, wherein the material of said anatomical model is chosen to be essentially homogeneous and with constant mass density.

3. The method according to claim 1 or 2, further comprising the step of calculating the SAR values at locations within the interior of said anatomical model from said field strength values at locations within the interior of said anatomical model.

4. The method according to one of claims 1 to 3, wherein the step of performing a numerical transformation includes solving the occurring differential equations and the corresponding border value problem, preferably including equivalent sources or a multipole evaluation.

5. The method according to one of claims 1 to 3, wherein the step of performing a numerical transformation includes using a Green Function resulting from the occuring differential equations such that the measured field strength values at locations on the surface of said anatomical model yield sources of the field within the interior of said anatomical model in accordance with the Huygen's principle.

6. A device for determining the electrical field strength acting on an anatomical model (10) made of a solid material and having a predetermined material distribution comprising:

    a probe matrix arranged on the surface of said anatomical model (10), said probe matrix comprising a plurality of individual probes (100-111) for measuring a parameter reflecting the electrical field strength at the probe loca- tion; and

    a controller (50) for controlling the measurement of the individual probes (100-111) and for performing a numerical transformation on the measured field strength values in order to obtain field strength values at locations within the interior of said anatomical model (10).

7. The device according to claim 1, wherein the material of said anatomical model (10) is chosen to be essentially homogeneous and with constant mass density.

8. The device according to claim 1 or 2, wherein the controller (50) is arranged for calculating the SAR values at locations within the interior of said anatomical model from said field strength values at locations within the interior of said anatomical model.

9. The device according to one of claims 1 to 3, wherein the controller (50) is arranged for solving the occurring differential equations and the corresponding border value problem, preferably including eqiuvalent sources or a multipole evaluation.

10. The device according to one of claims 1 to 3, wherein the controller (50) is arranged for using a Green Function resulting from the occuring differential equations such that the measured field strength values at locations on the surface of said anatomical model yield sources of the field within the interior of said anatomical model in accordance with the Huygen's principle.

## FIG 1A

50

100  101  102

103  104  105  10

106  107  108

A  109  110  111  A'

## FIG 1B

5

109  111

A  50  A'

110  EW

10

FIG 2

5 ✳ EW

10

100-111

50

501

502

503

FIG 3

30

35

E_M

EW

5

1

**European Patent Office**

## EUROPEAN SEARCH REPORT

Application Number

EP 99 11 4388

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | KUSTER N ET AL: "DOSIMETRIC EVALUATION OF HANDHELD MOBILE COMMUNICATIONS EQUIPMENT WITH KNON PRECISION" IEICE TRANSACTIONS ON COMMUNICATIONS,JP,INSTITUTE OF ELECTRONICS INFORMATION AND COMM. ENG. TOKYO, vol. 80-B, no. 5, page 645-651 XP000723037 ISSN: 0916-8516 * abstract * * page 646, column 1, paragraph 3 - page 647, column 1, paragraph 1 * * page 650, column 2, paragraph 3 * * figure 1 * | 1,6 | G01R31/08 G01R31/28 G01R31/00 |
| A | KUSTER N: "MULTIPLE MULTIPOLE METHOD FOR SIMULATING EM PROBLEMS INVOLVING BIOLOGICAL BODIES" IEEE TRANSACTIONS ON BIOMEDICAL ENGINEERING,US,IEEE INC. NEW YORK, vol. 40, no. 7, page 611-620 XP000434883 ISSN: 0018-9294 * page 612, column 2, paragraph 4 - page 613, column 1, paragraph 1 * * page 615, column 2, paragraph 4 - page 617, column 2, paragraph 3 * | 1,6 | TECHNICAL FIELDS SEARCHED (Int.Cl.7) G01R |
| A | HOMBACH, MEIER: "The dependence of EM energy absorption upon human head modeling at 900Mhz" IEEE TRANSACTIONS ON MICROWAVE THEORY AND TECHNIQUES, vol. 44, no. 10, October 1996 (1996-10), pages 1865-1873, XP002125147 * page 1866, column 1, paragraph 2 - page 1867, column 1, paragraph 1 * * page 1871, column 1, paragraph 1 - column 2, paragraph 2 * | 1,6 | |

-/--

The present search report has been drawn up for all claims

| Place of search | Date of completion of the search | Examiner |
|---|---|---|
| THE HAGUE | 9 December 1999 | Lopez-Carrasco, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

**European Patent Office**

## EUROPEAN SEARCH REPORT

Application Number

EP 99 11 4388

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | HINRIKUS, LASS: "The sensitivity of living tissue to microwave field" PROC. OF THE 20TH ANNUAL INT. CONF. OF THE IEEE ENG. IN MEDICINE AND BIOLOGY SOCIETY, vol. 20, no. 6, October 1998 (1998-10), pages 3249-3252, XP002125148 * page 3251, column 1, paragraph 3 - page 3252, column 1, paragraph 4 * | 1,6 | |

TECHNICAL FIELDS SEARCHED (Int.Cl.7)

The present search report has been drawn up for all claims

| Place of search | Date of completion of the search | Examiner |
|---|---|---|
| THE HAGUE | 9 December 1999 | Lopez-Carrasco, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)